# EUROPEAN PATENT APPLICATION

(11) **EP 2 333 136 A1**
(43) Date of publication of application: **15.06.2011**
(21) Application number: 09815870.2
(22) Date of filing: 18.09.2009
(51) Int. Cl.: C25B 11/12, C02F 1/46, C23C 16/27, C25B 1/28, C25B 11/04

(54) **DIAMOND ELECTRODE AND METHOD FOR MANUFACTURING DIAMOND ELECTRODE**

(30) Priority: 24.09.2008 JP 2008243979
(71) Applicant: Kurita Water Industries Ltd., Tokyo 160-8383 (JP); Sumitomo Electric Hardmetal Corp., Itami-shi Hyogo 664-0016 (JP)
(72) Inventor: NAGAI, Tatsuo, Tokyo 160-8383 (JP); IKEMIYA, Norihito, Tokyo 160-8383 (JP); YOSHIDA, Katsuhito, Itami-shi Hyogo 664-0016 (JP); YOSHIDA, Shigeru, Itami-shi Hyogo 664-0016 (JP)
(74) Representative: Higgs, Jonathan
(86) International application number: PCT/JP2009/004723
(87) International publication number: WO 2010/035448

(57) **Abstract**

It is an object of the present invention to provide a diamond electrode not causing the separation of a diamond film even if used in such a severe application as electrolyzing electrolysis solution containing highly oxidizing material at high current density. The diamond electrode includes a diamond film 3 with a thickness of 20 µm or more. The diamond film 3 covers both surfaces of a substrate 1 in such a manner as to cover end surfaces 2a of the substrate 1. Both the surfaces of the substrate are covered with a plurality of diamond layers by repeating predetermined times a step of forming a diamond layer having a thickness of 10 to 30 µm on one of the surfaces of the substrate and then forming a diamond layer having a thickness of 10 to 30 µm on the other surface of the substrate. It is, thus, possible to form a nonporous surface of diamond film and prevent deterioration of an electrode caused by the separation of a diamond film.

## Description

### Technical Field

The present invention relates to a diamond electrode and a manufacturing method therefor, and especially to an oxidation resistant diamond electrode formed by covering surfaces of an electrically conductive substrate such as silicon with a diamond film and used especially for the electrolysis of highly oxidizing electrolysis solution.

### Background Art

Known methods for forming film of gas-phase synthesized diamond include microwave plasma CVD, hot filament CVD and DC arc jet plasma CVD. Diamond obtained by these methods normally exhibits electrical insulation, but electrically conductive diamond provided with electrical conductivity can be manufactured by adding impurity during the formation of film.
Since diamond is a chemically very stable substance and excellent in the endurance against oxidation, the above-mentioned electrically conductive diamond attracts attention as an electrode especially used for water treatment and electrolysis.
Important things as diamond-covered material to be used as an electrode are physical and chemical strength as well as adhesion strength, including the nonporousness of a diamond film, the low electrical resistance of a substrate and a diamond film in light of the power efficiency as an electrode, no separation by stress between a substrate and a diamond film generated by such as heat generated by current application or solution temperature, and the resistance against corrosive solution and electrolysis reaction.

For tool materials with excellent separation resistance, a method has been proposed, the method for enhancing adhesive strength between a substrate and a diamond film by forming protrusions and recesses on surfaces of the substrate by surface treatment or the like so as to generate the wedge effect between the substrate and the diamond film. In the field of diamond electrodes, however, a problem remains that seeds cannot be generated well in a deep part of a recessed region.
A diamond-covered electrode in which a metal substrate such as niobium (Nb) or tungsten (W) is used because of the excellent adhesiveness between a diamond film and the substrate is available in the market. It is, however, difficult to obtain nonporous diamond film. In addition, if crack generates in a diamond film, the metal substrate elutes into electrolysis solution. Electrode deterioration is, thus, caused. From such a probability, it will be especially risky to adopt an electrode covered with diamond depositing on a metal substrate in a system for supplying cleaning solution for electronic materials such as semiconductor wafers. In contrast to this, a silicon substrate, which provides high adhesiveness with diamond and can be used as a substrate having relatively large area, is suitable for a substrate for a diamond electrode. Non-Patent Document 1, however, describes that the endurance of a diamond electrode is insufficient by such as separation of an electrically conductive diamond film formed on a silicon substrate.
The above problems have been addressed so far, and such improvement proposals as described in Patent Documents 1 to 3, for example, are proposed.
In addition, since electric field concentrates on edge parts of an electrode, the edge parts are fragile and most likely to encounter separation. It is, therefore, also necessary to cover edge surfaces of a substrate with a diamond film. Although the objective is different, Patent Document 4 disclosed that even edge surfaces of a substrate are covered with a diamond film.

### [Related Art Documents]

### [Non-Patent Documents]

Non-Patent Document 1: "The 26th DENKAI GIJYUTU KENTOUKAI - SODA KOGYO GIJYUTU TOURONKAI YOKOUSHU ", pp1-4, 2002
Patent Documents

Patent Document 1: Patent Application Publication NO. 2000-313982
Patent Document 2: Patent Application Publication NO. 2004-231983
Patent Document 3: Patent Application Publication NO. 2007-538151
Patent Document 4: Patent Application Publication NO. 2003-73876

### Summary of the Invention

### Problems to be Solved by the Invention

Since the diamond electrodes disclosed in Patent Documents 1 to 3, however, are technically insufficient, it is difficult to say that these are electrodes with sufficient oxidation resistance especially when used in an application for electrolyzing a highly oxidizing electrolysis solution such as high-temperature and high-concentration sulfuric acid.
Although Patent Document 4 disclosed a diamond electrode with its edge surfaces of a substrate covered with a diamond film as mentioned above, it is very difficult to form a diamond film on edge surfaces of a substrate practically without treatment, and it unfavorably takes a long time especially when increasing the thickness of the diamond film on the edge surfaces to a desired thickness.

The present invention was achieved under the above circumstances. It is an object of the present invention to provide a diamond electrode not causing the separation of a diamond film even if used in such a severe application as electrolyzing electrolysis solution containing highly oxidizing material at high current density, and a method for manufacturing the diamond electrode.

### Means for Solving the Problems

A diamond electrode according to a first aspect of the present invention includes: a diamond film having a thickness of 20 µm or more.

A second aspect of the present invention is characterized that the diamond film may include a plurality of diamond layers including layers having different characters from one another in the diamond electrode according to the first aspect of the present invention.

A third aspect of the present invention is characterized that at least a top diamond layer of the plurality of diamond layers may have a thickness of 20 µm or in the diamond electrode according to the second aspect of the present invention.

A fourth aspect of the present invention is characterized that the diamond electrode may consist of a substrate and the diamond film covering at least one surface of the substrate according to any one of the first to third aspects of the present invention.

A fifth aspect of the present invention is characterized that the diamond film may cover both surfaces of the substrate in the diamond electrode according to any one of the first to the fourth aspects of the present invention.

A sixth aspect of the present invention is characterized that the diamond film on one of the surfaces of the substrate may have a thickness of more than 20 µm, and the diamond film on the other surface of the substrate may have a thickness of 20 µm or more and of less than the thickness of the diamond layer on the one surface in the diamond electrode according to the fifth aspect of the present invention.

A seventh aspect of the present invention is characterized that the diamond film may cover the substrate up to edge surfaces of the substrate in the diamond electrode according to any one of the fourth to sixth aspects of the present invention.

A eighth aspect of the present invention is characterized that edge parts of the substrate may be chamfered in the diamond electrode according to the seventh aspect of the present invention.

A ninth aspect of the present invention is characterized that as conditions of the chamfering, a size of the chamfering may be an angle of 45 degrees or less with respect to a principal surface of the substrate, and a width of the chamfering may be 0.1 to 0.5 times as small as the thickness of the substrate in the diamond electrode according to the eighth aspect of the present invention.

A tenth aspect of the present invention is characterized that the substrate may be composed of electrically conductive material having a thickness of 1 to 6 mm in the diamond electrode according to any one of the fourth to ninth aspects of the present invention.

An eleventh aspect of the present invention is characterized that he substrate may be composed of electrically conductive silicon having a volume resistivity of 1 ohm-cm or less in the diamond electrode according to any one of the fourth to tenth aspects of the present invention.

A twelfth aspect of the present invention is characterized that the diamond electrode according to any one of the first to eleventh aspects of the present invention may be used as an electrode to electrolyze electrolysis solution containing highly oxidizing material.

A thirteenth aspect of the present invention is characterized that the electrolysis solution may be sulfuric acid solution at a temperature of 30 to 80 °C and a concentration of 70 to 96 mass percent in the diamond electrode according to the twelfth aspect of the present invention.

A fourteenth aspect of the present invention is characterized that a current density of 30 to 150A/dm² may be applied when the electrolysis solution is electrolyzed in the diamond electrode according to the twelfth or thirteenth aspect of the present invention.

A fifteenth aspect of the present invention is characterized that a method for manufacturing a diamond electrode includes: forming a diamond layer on a surface of a substrate, the forming divided into two or more steps, so as to cover the surface of the substrate with a diamond film having a thickness of 20 µm or more.
A sixteenth aspect of the present invention is characterized that the method for manufacturing a diamond electrode according to the fifteenth aspect of the present invention may include: forming the diamond layer on both surfaces of the substrate, the forming divided into two or more steps, so as to cover both the surfaces of the substrate with a diamond film having a thickness of 20 µm or more.
A seventeenth aspect of the present invention is characterized that the method for manufacturing a diamond electrode according to the sixteenth aspect of the present invention may include: repeating predetermined times a step of forming a diamond layer having a thickness of 10 to 30 µm on one of surfaces of the substrate and then forming a diamond layer having a thickness of 10 to 30 µm on the other surface of the substrate so as to cover both the surfaces of the substrate with a plurality of diamond layers.
An eighteenth aspect of the present invention is characterized that the diamond layer may be formed on edge surfaces of the substrate with the progress of the formation of the diamond layer on the surface of the substrate in the method for manufacturing a diamond electrode according to any one of the fifteenth to seventeenth aspects of the present invention.
A nineteenth aspect of the present invention is characterized that edge parts of the substrate may be chamfered before covering with the diamond layer in the method for manufacturing a diamond electrode according to any one of the fifteenth to eighteenth aspects of the present invention.
A twentieth aspect of the present invention is characterized that when forming the diamond layer, boron at 1,000 to 20,000 ppm to the carbon content in the diamond may be doped to the diamond in the method for manufacturing a diamond electrode according to any one of the fifteenth to nineteenth aspects of the present invention.

### Effect of the Invention

According to the present invention, it is possible to obtain a nonporous surface of a diamond film by increasing the thickness of a diamond film to a predetermined value or more. It is, thus, possible to prevent the deterioration of an electrode by the separation of a diamond film. The present invention is especially effective for a diamond-covered electrode including a diamond film covering at least one surface of a substrate.
In a diamond-covered electrode of the present invention, predetermined chamfering is applied to edge parts of a substrate, and a diamond film with a thickness of a predetermined value or more is formed even on edge surfaces of the substrate too. It is, thus, possible to realize the excellent fixation between a substrate and diamond even at the edge parts of the substrate, and prevent the deterioration by the concentration of electric field on the edge parts. It is, therefore, possible to manufacture a diamond electrode able to prevent the deterioration of an electrode by the separation of a diamond film

### Brief Description of the Drawings

Figure 1 shows a state where chamfering is applied to a substrate used for a diamond electrode of the present invention;
Figure 2 shows a process for forming a diamond layer on the substrate used for a diamond electrode of the present invention.

### Embodiment for Carrying out the Invention

The present invention is now described in detail below.

### 1) About covered substrate electrode

Since diamond-covered electrode is expensive and a compact electrolysis cell including electrodes is preferable, a bipolar electrode structure is often adopted in electrolysis equipment industrially used. In the bipolar electrode structure, a mere electrode not directly connected to a direct current power supply is placed between the anode and the cathode. There, however, has been no case that an diamond-covered electrode is industrially used. Diamond-covered electrodes currently available from diamond manufacturers are only a type that one surface of a substrate is covered with diamond.

When a diamond-covered electrode is employed in a cleaning process of electronic materials such as semiconductor wafers, not metal but silicon that is the same material as wafers is preferable as the material of a substrate as mentioned above in light of any possibility of cracking. Also in light of power efficiency as an electrode, it is preferable to use electrically conductive silicon with a volume resistivity of 1 ohm-cm or less so that the electrical resistance values of a substrate and a diamond film are approximately equal to that of covering diamond.

### 2) About forming diamond layer with large thickness

If there are microscopic pores called pinholes, a diamond film separates from a substrate with hydrogen, oxygen or the like that is generated in an electrolysis process. It is, therefore, necessary to eliminate microscopic pores especially when used for the electrolysis of corrosive solution. Diamond deposition becomes a diamond film in the form of the growth of diamond powder seeded on a surface of a substrate. If the diamond film is not formed sufficiently thick, the diamond film can not entirely cover a surface of a substrate, resulting in possible microscopic pores in the diamond film. Forming a thicker film can create a state in which a substrate is completely covered, thereby forming a nonporous diamond film. From such a point of view, the thickness of a diamond film should be 20 µm or more.

Tensile stress that is internal stress, however, is generated in a diamond film. Larger tensile stress causes the unfavorable separation of a diamond film from a substrate. It is, thus, preferable to equalize tensile stress applied to a substrate by forming a diamond film on both surfaces of a substrate. In addition, as the thickness of a film becomes thicker, tensile stress becomes larger. The thickness of a diamond film, thus, is preferably 100 µm or less.
When the thickness of a diamond film is less than 20 µm, the growth of diamond crystals is insufficient, causing the possible existence of microscopic pores as mentioned above. On the contrary, the thickness of a diamond film more than 100 µm is not preferable, since not only the above-mentioned problem of larger tensile stress but diamond film forming cost also becomes large, and the feasibility of industrial application is lowered. The possibility of the thickness of a diamond film more than 100 µm, however, is not denied, if the process time and cost of forming diamond film can be reduced through future improvements.

When used for electrolysis, a diamond electrode of the present invention may be used for the anode or the cathode, or can be used for a bipolar electrode.

In the diamond electrode, one surface of a substrate may be covered as mentioned above, or both surfaces thereof may be covered.

When highly oxidizing electrolysis solution such as low-temperature high-concentration sulfuric acid is electrolyzed using a diamond electrode, the thickness of a diamond film is preferably 30 µm or more to achieve higher strength. In other words, under a severe electrolysis condition, electrode deterioration may occur if the level of nonporousness is not high. It is, therefore, preferable to use a diamond electrode with a higher level of nonporousness. An example of the severe electrolysis condition referred to herein is the electrolysis of electrolysis solution containing highly oxidizing material. Since sulfuric acid solution of a temperature of 30 to 80 °C (especially 30 to 50 °C) and a concentration of 70 to 96 mass percent (especially 80 to 96 mass percent), for example, has very strong oxidation power. The electrolysis of this sulfuric acid solution, thus, may cause electrode deterioration if the level of nonporousness is not high. Since the current density of 30 to 150A/dm² during electrolysis is also severe as an electrolysis condition, it is necessary to increase the level of nonporousness.

When highly oxidizing electrolysis solution is electrolyzed, the cathode side is less likely to wear than the anode side. It is, therefore, possible to decrease the thickness of a diamond film on the cathode side relative to the thickness of a diamond film on the anode side. Even if highly oxidizing electrolysis solution is electrolyzed, the thickness of a diamond film on the anode side, thus, may be set at 30 µm or more (more preferably 50 µm or more), and the thickness of a diamond film on the cathode side may be set at 20 µm or more.

When a substrate with at least one surface thereof covered with a diamond film is used as the anode or the cathode for electrolyzing highly oxidizing electrolysis solution, a surface in contact with electrolysis solution (electrolyzing surface) is more likely to wear and a surface not in contact with electrolysis solution (non-electrolyzing surface) is hardly likely to wear. The electrolyzing surface, thus, may be covered with a diamond film with a thickness of 20 µm or more, while the non-electrolyzing surface may not be covered with a diamond film or covered with a thin diamond film with a thickness of less than 20 µm. It is, therefore, possible not to increase more than necessary the thickness of a diamond film of the non-electrolyzing surface that is less likely to wear. In consideration of the likelihood of wear, however, the non-electrolyzing surface may be covered with a diamond film with a thickness of 20 µm or more.
Since the anode is more likely to wear relative to the cathode as mentioned above, it is preferable to set the thickness of a diamond film of the electrolyzing surface of the anode at 30 µm or more, more preferably 50 µm or more. In order to form the non-electrolyzing surface, a structure of electrolysis tank may be adopted in which an electrode is sealed such that only one surface thereof is in contact with electrolysis solution.

If a bipolar electrode is manufactured by covering both surfaces of a substrate with a diamond film, a surface on the side to be the anode (one surface) by polarization by current application is relatively more likely to wear, and a surface on the side to be the cathode (the other surface) by polarization by current application is relatively less likely to wear.
Therefore, by setting the thickness of a diamond film on one surface of a bipolar electrode at more than 20 µm (preferably 30 µm or more, more preferably 50 µm or more) and setting the thickness of a diamond film on the other surface of the bipolar electrode at 20 µm or more and less than the thickness of the diamond film on the one surface, it is possible to sufficiently increase the thickness of a diamond film on the side more likely to wear without increasing more than necessary the thickness of a diamond film on the other side less likely to wear. As a result, electrode wear can effectively be prevented.

Since the formation of a diamond film with a large thickness, however, takes a very long time, it is a very large problem for the present invention. Here, it is possible to reduce a formation time of a diamond film by covering with a plurality of diamond layers of different characters as disclosed in Patent Document 2. The plurality of diamond layers are covered, for example, by covering a substrate side with a low-quality diamond layer for a short time, and then covering a side in contact with liquid with a high-quality diamond layer for a long time. As a result, the total time for forming the diamond can be shorten.
With respect to the plural layer type, it is possible to surely obtain the function as a nonporous film with a top diamond layer. The top diamond layer preferably has a thickness of 20 µm or more.
Needless to say, the present invention is not limited to the plural layer type but may include a type of a single layer of same character. If both surfaces of a substrate are covered with a diamond layer, one surface may be covered with the above single layer or both surfaces may be covered with the single layer.

### 3) About covering of front and back surfaces and edge surfaces

In a normal method for forming a diamond film on both surfaces of a substrate, first, a layer is formed on one surface and then the substrate is turned over to form a layer on a back surface. Since diamond deposits on edge surfaces of the substrate by the wrapping-around of diamond, the thickness of a diamond film depositing on the edge surfaces of the substrate is thinner than the thickness of the diamond film on both the surfaces of the substrate. Especially when used for the electrolysis of corrosive solution, it is necessary to deposit a nonporous diamond film on edge surfaces as well.

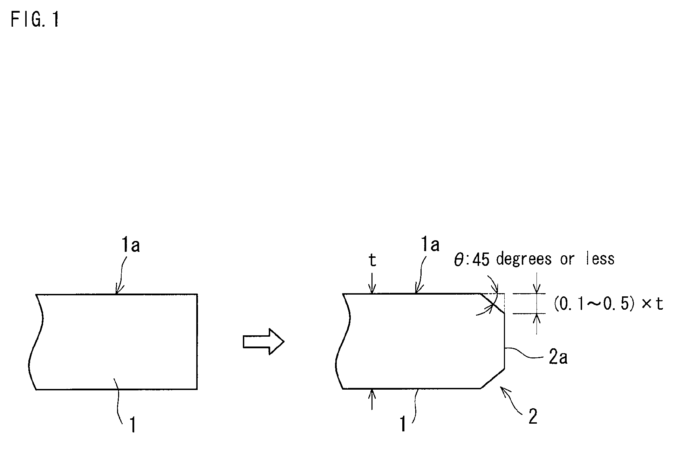

As shown in Figure 1, by chamfering edge parts 2 of a substrate 1, electric field being likely to concentrate on the edge parts 2 during electrolysis, it is possible to not only prevent the electric field concentration, but also facilitate the wrapping of a diamond film around the edge parts 2, and decrease the width of edge surfaces 2a. As a result, a diamond film depositing on the edge surfaces 2a by the wrapping-around has larger thickness. The width of edge surfaces is determined with the thickness of a substrate and the size of chamfering. Since larger chamfering reduces the width of the edge surfaces 2a, it is possible to increase the thickness of a diamond film by the wrapping-around. Since chamfering is applied from both surfaces, the maximum working width for chamfering is 0.5 times as small as the thickness t of a substrate. If the working of the maximum working width, however, is applied, principal surfaces 1a may be unfavorably reduced with chamfering angle mentioned later. The width of chamfering is preferably in the range between 0.1 or more times as small as the thickness of a substrate and 0.5 or less times as small as the same, that is, (0.1 to 0.5) x t, more preferably, in the range between 0.1 or more times as small as the thickness of a substrate and 0.33 or less times as small as the same, that is, (0.1 to 0.33) x t.

The size of chamfering preferably is an angle θ that is 45 degrees or less with respect to a principal surface of a substrate and that is an angle as small as possible. Too small angle, however, unfavorably reduces the effect of reducing the width of edge surfaces relative to the thickness of a substrate, or too large working width unfavorably reduces the area of principal surfaces. It is, thus, more preferable to perform the chamfering of an angle from 30 degrees to 45 degrees with respect to a principal surface.

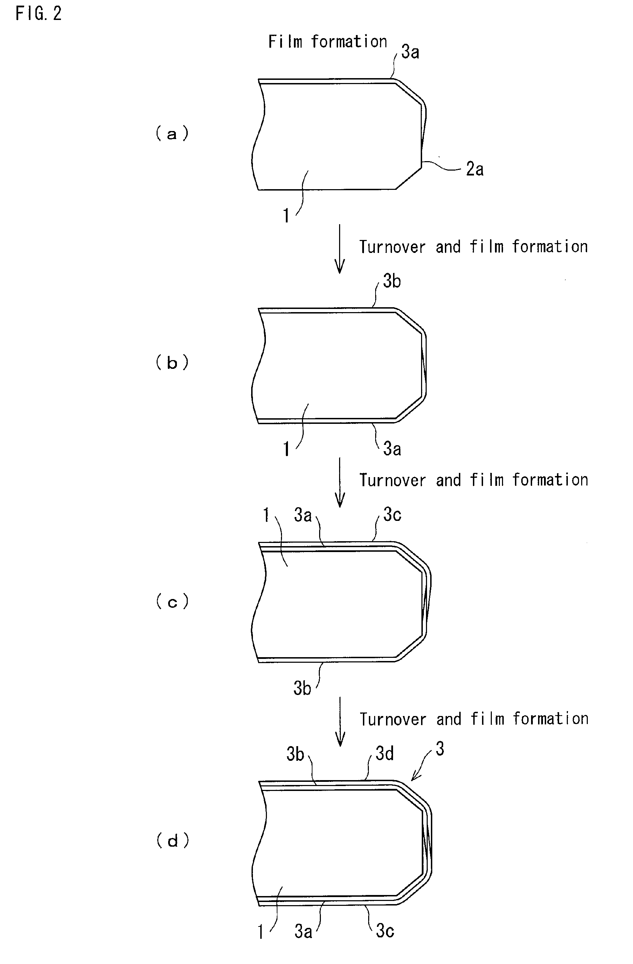

Figure 2 shows an example of a process for forming a diamond film on both surfaces of the substrate 1 chamfered as mentioned above, the process divided into two or more steps. This example of the process is explained with reference to the figure. First, a diamond layer 3a is formed on one surface of the substrate 1. During this film formation, the diamond layer wraps around the edge surfaces 2a to form a thin diamond layer even on a part of the edge surfaces 2a (Step a). The substrate 1 is turned over so that a diamond layer 3b is similarly formed on the other surface on the upper side. Also during this film formation, the diamond layer wraps around the edge surfaces 2a, and a part of the diamond layer on the tip side is consequently layered on the diamond layer previously formed by the wrapping-around (Step b). By repeating these steps (Steps c and d ), diamond layers 3a and 3c of two layers and diamond layers 3b and 3d of two layers are formed on the front and back surfaces, respectively. In other words, the substrate 1 is covered with a diamond layer 3 including the plurality of layers and having the thickness of 20 µm or more. Diamond layers having wrapped around during each film formation are layered on the edge surfaces 2a, and the edge surfaces 2a are covered with a diamond layer having sufficient thickness.

In this example for explanation, plural layers are formed by layering diamond layers of two layers on each of surfaces. One diamond layer or plural layers of three or more layers, however, may be layered on each of surfaces. In addition, the number of layers may be different between both surfaces. The number of layers, however, is desirably same for the purpose of equalization of the internal stress of a substrate.

### 4) About silicon substrate

The thinner the thickness of a silicon substrate is, the easier a diamond film wraps around edge surfaces. If the thickness is 6 mm or less, edge surfaces can be completely covered by the wrapping-around. If a too thin silicon substrate, however, is used, the substrate may be cracked by the stress applied during the covering with a diamond film. The thickness of a substrate, therefore, is preferably 1 mm or more and 6 mm or less, more preferable 4 mm or less because of the same reason.

A diamond electrode is given electrical conductivity by doping a predetermined amount of boron when a diamond film is formed. If the amount of doping is too little, it will generate no technical significance, or if it is too much, the doping effect is saturated. A suitable amount, therefore, is in the range of 1,000 to 20,000 ppm with respect to the carbon content of a diamond film.

### 5) About nonporousness

The level of "nonporousness" referred to herein is a level where neither separation nor pinholes of a diamond layer can be recognized even by examining the condition of surfaces of an electrode with a laser microscope and a scanning electron microscope.

### 6) About film forming procedure

An electrically conductive silicon substrate of a volume resistivity of 1 ohm-cm or less with its edge parts chamfered is used. The surfaces of the substrate are processed so that the maximum height Rmax is 0.5 to 3 µm and average roughness Ra is 0.2 to 1.5 µm. After cleaning the entire surfaces of the substrate, first, diamond powder is seeded on surfaces to be covered with diamond and then a film is formed.

As synthesis methods of an electrically conductive diamond, plasma CVD method and hot filament CVD method are preferable in consideration of the uniformity of a diamond film with respect to a covered area of a substrate and the denseness of a diamond film. An example of conditions of film forming by hot filament CVD method is described below, but the present invention is not limited to this example.

The example of conditions of diamond film forming by hot filament CVD method is: a process pressure of 4.0 kPa; and hydrogen, methane and trimethyl borate used as introduced gases, the mixing volume ratio of hydrogen and methane being 100:1 to 100:3, and a small amount of trimethyl borate added to the mixture.

### Example 1

Next, examples of the present invention and reference examples are described, but the present invention is not limited to the examples.

### [Examples 1-3, Reference example 1] (Difference in thickness of diamond layer, electrolysis of high-concentration sulfuric acid)

Electrically conductive silicon substrates (12 cm square and 3 mm thick) each having a volume resistivity of 0.5 ohm-cm were used. Edge parts of each substrate were subjected to the chamfering having a size of a width of 0.3 mm and an angle of 45 degrees. Surfaces of each substrate were adjusted to the maximum height of 1 µm and average roughness of 0.5 µm. After cleaning the entire surfaces of each substrate, first, diamond powder was seeded and then film forming was started. Hot filament CVD method was adopted for the film formation: a process pressure was 4 kPa, hydrogen, methane and trimethyl borate were used as introduced gases. The mixing volume ratio of hydrogen and methane was 100:2 and a small amount of trimethyl borate was added to the mixture. During the formation of a diamond layer, boron of 5,000 ppm with respect to carbon content was doped to provide electrical conductivity. Under predetermined conditions for the thicknesses of a diamond film (10, 20, 30 and 50 µm), a film was formed on both surfaces of each substrate in such a manner as to cover its edge surfaces as well. A electrolysis cell was constructed using each set of five diamond electrodes produced in this way to electrolyze sulfuric acid solution of 50 °C and 85 mass percent. A continuous operation was performed at a current density of 30A/dm² for 200 hours.

As to an electrolysis cell using diamond electrodes with the thickness of a diamond film of 10 µm (reference example 1), the electrolysis voltage during the operation became unstable after about 30 hours as shown in Table 1. After the electrolysis, the electrolysis cell was disassembled and surfaces of the electrodes were examined to find that about 15% of diamond film of the electrodes separated from the substrates.
As to electrolysis cells each using diamond electrodes with the thickness of a diamond film of 20, 30 or 50 µm (examples 1 to 3), the electrolysis voltage measured during operation was stable at 20 V. After the electrolysis, each electrolysis cell was disassembled, and the condition of surfaces of the electrodes was examined with a laser microscope and a scanning electron microscope. As shown in Table 1, neither separation nor pinholes of the diamond layers were observed.

**[Table 1]**

| | Thickness of diamond film | Deterioration time of electrode plain surface |
|---|---|---|
| Reference example 1 | 10 µm | 30 hours |
| Example 1 | 20 µm | No deterioration occurred after 200 hours. |
| Example 2 | 30 µm | No deterioration occurred after 200 hours. |
| Example 3 | 50 µm | No deterioration occurred after 200 hours. |

### [Example 4, Example 5] (Difference in thickness of diamond film, electrolysis of low-temperature high-concentration sulfuric acid)

Under the same condition as example 1 and example 2 except a temperature of sulfuric acid solution to be electrolyzed at 30 °C, the temperature being a severer electrolysis condition, sulfuric acid solution was similarly electrolyzed as above. The operation was continued at a current density of 30A/dm² for 200 hours.

As to an electrolysis cell using diamond electrodes with the thickness of a diamond film of 20 µm (example 4), in contrast with no deterioration after 200 hours in the above example 1, the electrolysis voltage during operation became unstable after about 150 hours in this example under the temperature of sulfuric acid solution at 30 °C as shown in Table 2. After the electrolysis, the electrolysis cell was disassembled and surfaces of the electrodes were examined to find that about 5% of the diamond film of the electrodes separated from the substrates.

On the other hand, as to an electrolysis cell using diamond electrodes with the thickness of a diamond film of 30 µm (example 5), the electrolysis voltage measured during the operation was stable at 20 V. After the electrolysis, the electrolysis cell was disassembled and the condition of surfaces of the electrodes were examined with a laser microscope and a scanning electron microscope, but neither the separation nor pinholes of the diamond layers were observed. These results indicate that, under a severer electrolysis condition, it is preferable to set the thickness of a diamond film at 30 µm or more.

**[Table 2]**

| | Thickness of diamond film | Deterioration time of electrode plain surface |
|---|---|---|
| Example 4 | 20 µm | 150 hours. |
| Example 5 | 30 µm | No deterioration occurred after 200 hours. |

### [Example 6] (Difference in condition of chamfering at edge parts of substrate)

Electrically conductive silicon substrates (size of 12 cm square) each with one of the various substrate thicknesses and one of the various chamfering sizes at edge parts as shown in Table 3 were prepared.

A film of electrically conductive diamond was formed on each of electrically conductive silicon substrates in the same way as in example 3. An electrolysis cell was similarly constructed as in the example 1 using each set of five diamond electrodes produced in this way and having the same chamfering width to electrolyze sulfuric acid solution of 30 °C and 85 mass percent. A continuous operation was performed at a current density of 30A/dm² for 200 hours.

After the electrolysis, the electrolysis cells were disassembled and the surface condition of the electrodes was examined. Neither separation nor pinholes of each diamond electrode were observed.

**[Table 3]**

| Test No. | Substrate thickness (mm) | Chamfering width (mm) | Chamfering width/ substrate thickness | Chamfering angle |
|---|---|---|---|---|
| 1 | 6 | 2.0 | 0.33 | 45 degrees |
| 2 | 6 | 1.5 | 0.25 | 30 degrees |
| 3 | 6 | 1.0 | 0.17 | 30 degrees |
| 4 | 3 | 1.5 | 0.50 | 45 degrees |
| 5 | 3 | 1.0 | 0.33 | 30 degrees |
| 6 | 3 | 0.5 | 0.17 | 20 degrees |
| 7 | 2 | 1.0 | 0.50 | 20 degrees |
| 8 | 2 | 0.5 | 0.25 | 10 degrees |
| 9 | 1 | 0.5 | 0.50 | 10 degrees |

### [Reference example 3]

Diamond electrodes were produced in the same way as in example 3 except that such electrically conductive silicon substrates each with one of the substrate thicknesses and one of the chamfering sizes at edge parts as shown in Table 4 were used. An electrolysis cell was constructed using each set of five diamond electrodes to electrolyze sulfuric acid solution of 85 mass percent. A continuous operation was performed at a current density of 30A/dm² for 50 hours. After the electrolysis, the electrolysis cells were disassembled and surfaces of each electrode were examined. As a result of the examination, a diamond film separated from a substrate at edge parts in all reference examples.

**[Table 4]**

| Test No. | Substrate thickness (mm) | Chamfering width (mm) | Chamfering width/ substrate thickness | Chamfering angle |
|---|---|---|---|---|
| 10 | 6 | 0.2 | 0.03 | 45 degrees |
| 11 | 6 | 0.3 | 0.05 | 30 degrees |
| 12 | 6 | 0.4 | 0.07 | 60 degrees |
| 13 | 3 | 0.4 | 0.13 | 50 degrees |
| 14 | 3 | 0.3 | 0.10 | 50 degrees |

### [Reference example 4]

Diamond electrodes were produced with the same surface roughness and film forming method as in example 3 except that substrates are composed of niobium (Nb). An electrolysis cell was constructed using a set of five diamond electrodes to electrolyze sulfuric acid solution of 85 mass percent. A continuous operation was performed at a current density of 30A/dm² for 40 hours. The electrolysis voltage during the operation became unstable after about 30 hours. After the electrolysis, the electrolysis cell was disassembled and the surfaces of the electrodes were examined to find that about 30% of the diamond film of the electrodes separated from the substrates.

### [Reference example 5]

Diamond electrodes were produced with the same surface roughness and film forming method as in example 3 except that each substrate was composed of p-type silicon with a diameter of 15 cm and a thickness of 1 mm and the thickness of each diamond film was 15 µm. An electrolysis cell was constructed using a set of five diamond electrodes to electrolyze sulfuric acid solution of 85 mass percent. A continuous operation was performed at a current density of 30A/dm² for 20 hours. The electrolysis voltage during the operation became unstable after about 15 hours. After the electrolysis, the electrolysis cell was disassembled and the surfaces of the electrodes were examined to find that about 50% of the diamond film of the electrodes separated from the substrates.

### [Reference example 6]

Diamond electrodes were produced in the same way as in example 3 except that substrates were composed of ceramic. An electrolysis cell was constructed using a set of five diamond electrodes to electrolyze sulfuric acid solution of 85 mass percent. A continuous operation was performed at a current density of 30A/dm² for 40 hours. Although the electrolysis voltage during the operation reached 40 V. Since it was, however, stable, the continuous operation was performed for 200 hours. After the electrolysis, the electrolysis cell was disassembled and the condition of the surfaces of the electrodes were examined with a laser microscope and a scanning electron microscope. Neither separation nor pinholes of substrates were observed. Electrolysis voltage, however, was two times as large as that of a diamond electrode composed of electrically conductive silicon substrate, that is, electricity cost doubles. It is, thus, found that this type of diamond electrode is not suitable for practical use.

### Explanation of Reference Numerals

1: Substrate
1a: Principal surface
2: Edge part
2a: Edge surface
3: Diamond film
3a: Diamond layer
3b: Diamond layer
3c: Diamond layer
3d: Diamond layer

## Claims

1. A diamond electrode, comprising:
a diamond film having a thickness of 20 µm or more.

2. The diamond electrode according to claim 1, wherein
the diamond film includes a plurality of diamond layers including layers having different characters from one another.

3. The diamond electrode according to claim 2, wherein
at least a top diamond layer of the plurality of diamond layers has a thickness of 20 µm or more.

4. The diamond electrode according to any one of claims 1 to 3, comprising:
a substrate; and
the diamond film covering at least one surface of the substrate.

5. The diamond electrode according to any one of claims 1 to 4, wherein
the diamond film covers both surfaces of the substrate.

6. The diamond electrode according to claim 5, wherein
the diamond film on one of the surfaces of the substrate has a thickness of more than 20 µm, and wherein
the diamond film on the other surface of the substrate has a thickness of 20 µm or more and of less than the thickness of the diamond layer on the one surface.

7. The diamond electrode according to any one of claims 4 to 6, wherein
the diamond film covers the substrate in such a manner up to edge surface of the substrate.

8. The diamond electrode according to claim 7, wherein
edge parts of the substrate are chamfered.

9. The diamond electrode according to claim 8, wherein
as conditions of the chamfering, a size of the chamfering is an angle of 45 degrees or less with respect to a principal surface of the substrate, and a width of the chamfering is 0.1 to 0.5 times as small as the thickness of the substrate.

10. The diamond electrode according to any one of claims 4 to 9, wherein
the substrate is composed of electrically conductive material having a thickness of 1 to 6 mm.

11. The diamond electrode according to any one of claims 4 to 10, wherein
the substrate is composed of electrically conductive silicon having a volume resistivity of 1 ohm-cm or less.

12. The diamond electrode according to any one of claims 1 to 11, used as an electrode to electrolyze electrolysis solution containing highly oxidizing material.

13. The diamond electrode according to claim 12, wherein
the electrolysis solution is sulfuric acid solution at a temperature of 30 to 80 °C and a concentration of 70 to 96 mass percent.

14. The diamond electrode according to claim 12 or 13, wherein
a current density of 30 to 150A/dm² is applied when the electrolysis solution is electrolyzed.

15. A method for manufacturing a diamond electrode, comprising:
forming a diamond layer on a surface of a substrate, the forming divided into two or more steps, so as to cover the surface of the substrate with a diamond film having a thickness of 20 µm or more.

16. The method for manufacturing a diamond electrode according to claim 15, comprising:
forming the diamond layer on both surfaces of the substrate, the forming divided into two or more steps, so as to cover both the surfaces of the substrate with a diamond film having a thickness of 20 µm or more.

17. The method for manufacturing a diamond electrode according to claim 16, comprising:
repeating predetermined times a step of forming a diamond layer having a thickness of 10 to 30 µm on one of surfaces of the substrate and then forming a diamond layer having a thickness of 10 to 30 µm on the other surface of the substrate so as to cover both the surfaces of the substrate with a plurality of diamond layers.

18. The method for manufacturing a diamond electrode according to any one of claims 15 to 17, wherein
the diamond layer is formed on edge surfaces of the substrate with the progress of the formation of the diamond layer on the surface of the substrate.

19. The method for manufacturing a diamond electrode according to any one of claims 15 to 18, wherein
edge parts of the substrate are chamfered before covering with the diamond layer.

20. The method for manufacturing a diamond electrode according to any one of claims 15 to 19, wherein,
when forming the diamond layer, boron at 1,000 to 20,000 ppm with respect to a carbon content of the diamond is doped to the diamond.
